# EUROPEAN PATENT APPLICATION

(11) **EP 4 776 801 A1**
(43) Date of publication of application: **15.07.2026**
(21) Application number: 24861897.7
(22) Date of filing: 30.08.2024
(51) Int. Cl.: H10H 20/858

(54) **DISPLAY CHIP AND DISPLAY APPARATUS AND PREPARATION METHOD THEREFOR**

(30) Priority: 04.09.2023 CN 202311134552
(71) Applicant: Beijing Zitiao Network Technology Co., Ltd., Beijing 100190 (CN)
(72) Inventor: HUANG, Zhen, Beijing 100028 (CN); WANG, Chenggong, Beijing 100028 (CN); LI, Duo, Beijing 100028 (CN); LI, Xiaokai, Beijing 100028 (CN)
(74) Representative: Marks & Clerk LLP
(86) International application number: PCT/CN2024/115753
(87) International publication number: WO 2025/051053

(57) **Abstract**

Provided are a display chip and a display apparatus and a preparation method therefor. The display chip comprises: an epitaxial layer, the epitaxial layer comprising a first semiconductor layer, a quantum well light-emitting layer, and a second semiconductor layer which are sequentially stacked and arranged; a first reflective layer, which is located on the side of the second semiconductor layer away from the first semiconductor layer; a first metal binding layer, which is located on the side of the first reflective layer away from an epitaxial structure; a heat dissipation layer, the heat dissipation layer comprising a first heat dissipation layer and/or a second heat dissipation layer. The first heat dissipation layer is located between the epitaxial structure and the first reflective layer, the second heat dissipation layer is located on the side of the first reflective layer away from the epitaxial structure, the second heat dissipation layer is provided with a first opening exposing the first reflective layer, and the first metal binding layer is arranged on the side of the second heat dissipation layer away from the first reflective layer and fills the first opening. The described structure may improve the heat dissipation performance of the display chip.

## Description

The present application claims priority of Chinese Patent Application No. 202311134552.7, filed on September 4, 2023, which is incorporated herein by reference in its entirety as a part of the present application.

### TECHNICAL FIELD

The present disclosure relates to a display chip and a display apparatus, and manufacturing methods thereof.

### BACKGROUND

At present, the heat dissipation performance of light emitting diodes (LEDs) needs to be further improved. In particular, with the development of science and technology, the size of LED is miniaturized, and display devices such as miniaturized micro light emitting diodes (Micro-LEDs) face more serious heat dissipation problems due to their high injection current density and high brightness.

### SUMMARY

The present disclosure provides a display chip and a display apparatus, and manufacturing methods thereof, which are able to improve the heat dissipation performance of the display chip.

An embodiment of the present disclosure provides a display chip, including:
an epitaxial layer, including a first semiconductor layer, a quantum well light-emitting layer, and a second semiconductor layer that are sequentially stacked, wherein one of the first semiconductor layer and the second semiconductor layer is an n-type semiconductor layer, and the other one of the first semiconductor layer and the second semiconductor layer is a p-type semiconductor layer;
a first reflective layer, located on a side of the second semiconductor layer away from the first semiconductor layer;
a first metal bonding layer, located on a side of the first reflective layer away from the epitaxial structure; and
a heat dissipation layer, including a first heat dissipation layer and/or a second heat dissipation layer, wherein the first heat dissipation layer is located between the epitaxial structure and the first reflective layer, the second heat dissipation layer is located on a side of the first reflective layer away from the epitaxial structure, the second heat dissipation layer is provided with a first opening that exposes the first reflective layer, and the first metal bonding layer is disposed on a side of the second heat dissipation layer away from the first reflective layer and fills the first opening.

An embodiment of the present disclosure provides a display apparatus, including a chip structure and a second substrate, wherein the chip structure is formed by the display chip described above, and the chip structure is bonded to the second substrate through the first metal bonding layer.

An embodiment of the present disclosure provides a manufacturing method of the display chip described above, including the following steps:
providing an epitaxial wafer for forming the epitaxial layer;
forming the first reflective layer on a side of the second semiconductor layer of the epitaxial wafer away from the first semiconductor layer; and
forming the first metal bonding layer on the first reflective layer,
wherein
the first heat dissipation layer is formed on the side of the second semiconductor layer of the epitaxial wafer away from the first semiconductor layer first, and then the first reflective layer is formed on a side of the first heat dissipation layer away from the second semiconductor layer;
   and/or
a dielectric layer is formed on a side of the first reflective layer away from the epitaxial wafer;
the dielectric layer is patterned to form a second opening that exposes the first reflective layer;
then the second heat dissipation layer that fills the second opening is formed;
the dielectric layer is etched and removed to form a first opening that exposes the first reflective layer; and
the first metal bonding layer is formed on the side of the second heat dissipation layer away from the first reflective layer, and the first metal bonding layer fills the first opening.

An embodiment of the present disclosure provides a manufacturing method of the display apparatus described above, including the following steps:
manufacturing the display chip according to the manufacturing method of the display chip described above; and
bonding the display chip to the second substrate through the first metal bonding layer to obtain the display apparatus.

In the display chip and the display apparatus, and the manufacturing methods thereof provided by the present disclosure, the first heat dissipation layer is disposed between the epitaxial structure and the first reflective layer and/or the second heat dissipation layer with the first opening is disposed on the side of the first reflective layer away from the epitaxial structure, and when the second heat dissipation layer exists, the first metal bonding layer is located on the side of the second heat dissipation layer away from the first reflective layer and fills the first opening. In this way, by disposing the first heat dissipation layer and/or the second heat dissipation layer with a specific structure, the heat dissipation performance of the display chip may be improved, and the performances such as the light-emitting brightness of the chip may be improved. The present disclosure is particularly applicable to improving the heat dissipation performance of a micro display device such as a Micro-LED and enhancing the performances such as the light-emitting brightness thereof.

### BRIEF DESCRIPTION OF THE DRAWINGS

Fig. 1 is a schematic diagram of a chip structure in which a dielectric layer is formed on a first reflective layer according to an embodiment of the present disclosure;
Fig. 2 is a schematic diagram of a chip structure after the dielectric layer of Fig. 1 is patterned according to an embodiment of the present disclosure;
Fig. 3 is a schematic diagram of a chip structure with a heat dissipation sub-layer (first heat dissipation layer) being formed on the first reflective layer of Fig. 2 according to an embodiment of the present disclosure;
Fig. 4 is a schematic diagram of a chip structure after the dielectric layer of Fig. 3 is removed according to an embodiment of the present disclosure;
Fig. 5 is a schematic diagram of a display chip structure with a first metal bonding layer being formed on the first reflective layer and the first heat dissipation layer of Fig. 4 according to an embodiment of the present disclosure;
Fig. 6 is a schematic diagram of a structure in which the display chip of Fig. 4 is bonded to a second substrate according to an embodiment of the present disclosure;
Fig. 7 is a schematic diagram of a structure in which a base layer in the display chip of Fig. 6 is removed according to an embodiment of the present disclosure;
Fig. 8 is a schematic diagram of a structure in which the display chip of Fig. 7 is etched into a preset chip structure according to an embodiment of the present disclosure;
Fig. 9 is a schematic diagram of a display apparatus structure in which various film layers are sequentially formed on a surface of the chip structure of Fig. 8 according to an embodiment of the present disclosure;
Fig. 10 is a schematic diagram of a structure in which the display chip of Fig. 7 is etched into a preset chip structure according to another embodiment of the present disclosure;
Fig. 11 is a schematic diagram of a display apparatus structure in which various film layers are sequentially formed on a surface of the chip structure of Fig. 10 according to an embodiment of the present disclosure;
Fig. 12 is a schematic diagram of a display chip structure according to another embodiment of the present disclosure;
Fig. 13 is a schematic diagram of a display apparatus structure formed using the display chip of Fig. 12 according to an embodiment of the present disclosure; and
Fig. 14 is a schematic diagram of a display apparatus structure according to another embodiment of the present disclosure.

### DETAILED DESCRIPTION OF EMBODIMENTS

In order to enable those skilled in the art to better understand the solutions of the present invention, the present invention will be further described in detail below. The specific implementations listed below are only for describing the principles and features of the present invention, and the examples are only for explaining the present invention, but not for limiting the scope of the present invention. All other implementations obtained by those of ordinary skill in the art without paying creative efforts based on the embodiments of the present invention belong to the scope of protection of the present invention.

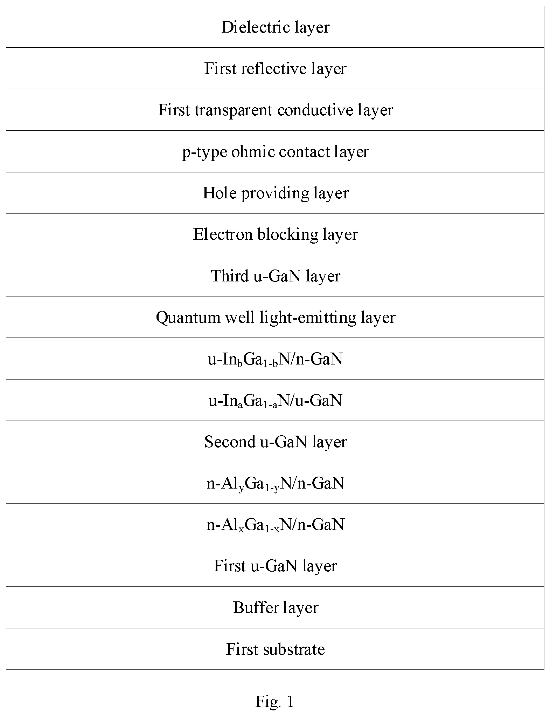

An embodiment of the present disclosure provides a display chip, and as shown in Fig. 1 to Fig. 14, the display chip includes: an epitaxial layer, including a first semiconductor layer, a quantum well light-emitting layer, and a second semiconductor layer that are sequentially stacked, wherein one of the first semiconductor layer and the second semiconductor layer is an n-type semiconductor layer, and the other one of the first semiconductor layer and the second semiconductor layer is a p-type semiconductor layer; a first reflective layer, located on a side of the second semiconductor layer away from the first semiconductor layer; a first metal bonding layer, located on a side of the first reflective layer away from the epitaxial structure; and a heat dissipation layer, including a first heat dissipation layer and/or a second heat dissipation layer, wherein the first heat dissipation layer is located between the epitaxial structure and the first reflective layer, the second heat dissipation layer is located on a side of the first reflective layer away from the epitaxial structure, the second heat dissipation layer is provided with a first opening that exposes the first reflective layer, and the first metal bonding layer is disposed on a side of the second heat dissipation layer away from the first reflective layer and fills the first opening.

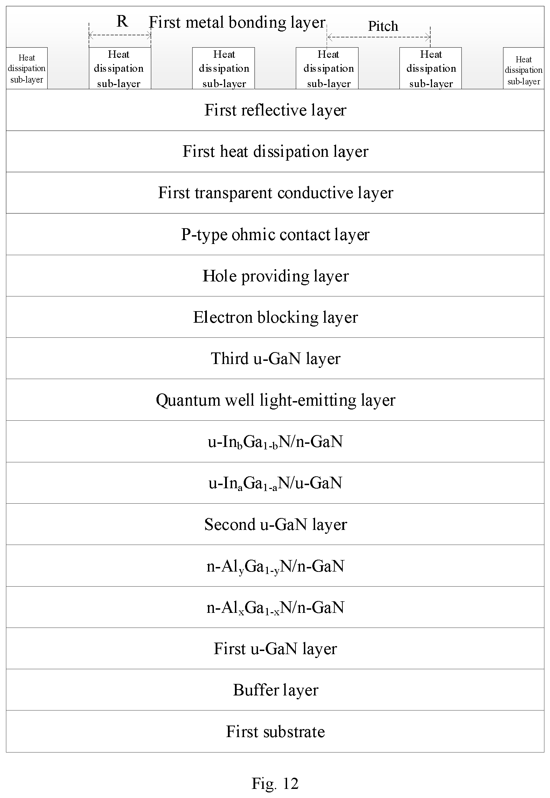

Exemplarily, as shown in Fig. 1 to Fig. 11, the above-mentioned display chip includes the first heat dissipation layer and the second heat dissipation layer; or, as shown in Fig. 12 to Fig. 14, the above-mentioned display chip includes the second heat dissipation layer.

Specifically, the heat dissipation layer may be formed of a material with a high thermal conductivity (heat conduction coefficient), and the thermal conductivity thereof may be greater than or equal to 2000 W/(m·K). By introducing the heat dissipation layer with the high thermal conductivity, the heat dissipation performance of the chip may be effectively ameliorated, and the brightness and other performances of the display chip (such as a Micro-LED) may be improved.

**In** some embodiments, the first heat dissipation layer may include a diamond material and/or a graphene material.

In some embodiments, the second heat dissipation layer may include a diamond material and/or a graphene material.

Specifically, the thermal conductivities of the graphene material and the diamond material may be about 5300 W/(m·K) and 2100 W/(m·K), respectively, which are higher than that of a silicon substrate and a metal film layer (for example, the thermal conductivities of a copper metal film layer and a silver metal film layer are about 400 W/(m·K) and 430 W/(m·K), respectively). Through forming the above-mentioned heat dissipation layer by using the diamond material and/or the graphene material, the heat dissipation performance of the chip is further ameliorated, and the performance such as the brightness of the display chip is improved.

**In** addition, the thickness of the first heat dissipation layer may be 100~300nm, such as 100nm, 130 nm, 150 nm, 180 nm, 200 nm, 230 nm, 250 nm, 280 nm, 300 nm, or in a range composed of any two of the above values.

**In** addition, the thickness of the second heat dissipation layer may be 10~20µm, such as 10µm, 11µm, 12µm, 13µm, 14µm, 15µm, 16µm, 17µm, 18µm, 19µm, 20µm, or in a range composed of any two of the above values.

Specifically, the first opening penetrates through the second heat dissipation layer to expose a surface of the first reflective layer, and the first metal bonding layer fills the first opening and covers the second heat dissipation layer and the first opening (that is, a projection of the first metal bonding layer on the first reflective layer covers a projection of the second heat dissipation layer on the first reflective layer and a projection of the first opening on the first reflective layer).

Specifically, the second heat dissipation layer may include a plurality of heat dissipation sub-layers, and every two adjacent heat dissipation sub-layers are spaced apart by the first opening.

A distance between centers of every two adjacent heat dissipation sub-layers may be 2~20µm, such as 2µm, 5µm, 8µm, 10µm, 13µm, 15µm, 18µm, 20µm, or in a range composed of any two of the above values.

**In** addition, a size of each heat dissipation sub-layer may be 1~10um, such as 1µm, 1µm, 2µm, 3µm, 4_{flll1}, 5µm, 6µm, 7µm, 8µm, 9µm, 10µm, or in a range composed of any two of the above values.

Specifically, a projection of the heat dissipation sub-layer on the first reflective layer may be circular, the size of the heat dissipation sub-layer is the diameter thereof (that is, the diameter of the projection of the heat dissipation sub-layer on the first reflective layer is 1~10µm), and the center of the heat dissipation sub-layer is the circle center thereof (that is, the distance between the centers of every two adjacent heat dissipation sub-layers is a distance between circle centers of the projections of the two adjacent heat dissipation sub-layers on the first reflective layer).

**In** addition, the first metal bonding layer is used for bonding the display chip to a second substrate, that is, the display chip is bonded to the second substrate through the first metal bonding layer, and the second substrate includes, for example, a silicon substrate or a silicon-based complementary metal oxide semiconductor (CMOS) pixel driving circuit.

Specifically, the first metal bonding layer includes a metal, such as one or more of chromium (Cr), platinum (Pt), nickel (Ni), titanium (Ti), silver (Ag), and the like. Exemplarily, the first metal bonding layer is a multi-layer structure, that is, the first metal bonding layer includes a plurality of metal layers, for example, includes a chromium layer, a platinum layer, a nickel layer, a titanium layer, a nickel layer, and a silver layer that are sequentially stacked on a side of the first reflective layer away from the first semiconductor layer.

**In** addition, the first reflective layer is used for enhancing light extraction efficiency of the display chip, and the first reflective layer may include silver (Ag), which may specifically be a silver mirror.

In addition, the thickness of the first reflective layer may be 100~300nm, such as 100nm, 130 nm, 150 nm, 180 nm, 200 nm, 230 nm, 250 nm, 280 nm, 300 nm, or in a range composed of any two of the above values.

The display chip of the embodiment of the present disclosure may be a vertical chip structure, such as a vertical Micro-LED chip structure. By using the material with high thermal conductivity, the heat dissipation performance of the chip may be improved and the light-emitting brightness of the chip may be enhanced.

In an implementation, as shown in Fig. 1 to Fig. 13, the above-mentioned epitaxial layer may be an InGaN-based epitaxial structure, the first semiconductor layer is an n-type semiconductor layer, the second semiconductor layer is a p-type semiconductor layer, and the above-mentioned quantum well light-emitting layer is an InGaN-based quantum well light-emitting layer, which may specifically be an InGaN-based quantum well light-emitting layer with a period of 3 to 6.

Specifically, the quantum well light-emitting layer includes one or more of a blue quantum well light-emitting layer, a green quantum well light-emitting layer, and a red quantum well light-emitting layer, and each of the blue quantum well light-emitting layer, the green quantum well light-emitting layer, or the red quantum well light-emitting layer is an InGaN-based quantum well light-emitting layer, which may specifically be an InGaN-based quantum well light-emitting layer with a period of 3 to 6.

Generally, the blue quantum well layer has an emission band (wavelength range) of 445~465nm, the green quantum well layer has an emission band of 515~535nm, and the red quantum well layer has an emission band of 615~630nm.

In some embodiments, the blue quantum well layer includes three to six first repeating units, each first repeating unit includes a u-InₘGa₁₋ₘN potential well layer and a u-In_{q}Ga_{1-q}N potential barrier layer that are sequentially stacked in a first direction (that is, the blue quantum well layer is a u-InₘGa₁₋ₘN/u-In_{q}Ga_{1-q}N quantum well structure with a period of 3 to 6), 0.18≤m≤0.21, 0.01≤q≤0.02, the u-InₘGa₁₋ₘN potential well layer may have a thickness of 2.5~3nm, and the u-In_{q}Ga_{1-q}N potential barrier layer may have a thickness of 10~15nm, such as 10nm, 11 nm, 12 nm, 13 nm, 14 nm, 15 nm, or in a range composed of any two of the above values.

In addition, the first repeating unit may further include a fourth u-GaN layer, and the fourth u-GaN layer, the u-InₘGa₁₋ₘN potential well layer, and the u-In_{q}Ga_{1-q}N potential barrier layer are arranged in a stacked manner. In specific implementation, the fourth u-GaN layer may be deposited before the film formation of the u-InₘGa₁₋ₘN potential well layer and the u-In_{q}Ga_{1-q}N potential barrier layer, and this growth mode may effectively alleviate the wavelength shift problem under a large current injection, and the performance of the display chip is further optimized. The fourth u-GaN layer may have a thickness of 2~3nm.

In some embodiments, the green quantum well light-emitting layer may include one to two second repeating units and two to three third repeating units.

Each second repeating unit includes a u-In_{w}Ga_{1-w}N potential well layer and a first n-GaN potential barrier layer that are arranged in a stacked manner (that is, the second repeating unit is a u-In_{w}Ga_{1-w}N/n-GaN quantum well structure), 0.24≤w≤0.25, the u-In_{w}Ga_{1-w}N potential well layer has a thickness of 2.5~3nm, the first n-GaN potential barrier layer has a thickness of 10~15nm, and a Hall electron concentration of 5×10¹⁷~6×10¹⁷cm⁻³.

In addition, the second repeating unit may further include a fifth u-GaN layer, and the fifth u-GaN layer, the u-In_{w}Ga_{1-w}N potential well layer, and the first n-GaN potential barrier layer are arranged in a stacked manner. In specific implementation, the fifth u-GaN layer may be deposited before the film formation of the u-In_{w}Ga_{1-w}N potential well layer and the first n-GaN potential barrier layer, and this growth mode may effectively alleviate the wavelength shift problem under a large current injection, and the performance of the display chip is further optimized. The fifth u-GaN layer may have a thickness of 2~3nm.

Each third repeating unit includes a u-In_{z}Ga_{1-z}N potential well layer and a second n-GaN potential barrier layer that are arranged in a stacked manner (that is, the third repeating unit is a u-In_{z}Ga_{1-z}N/n-GaN quantum well structure), 0.25≤z≤0.28, the u-In_{z}Ga_{1-z}N potential well layer has a thickness of 2.5~3nm, the second n-GaN potential barrier layer has a thickness of 10~15nm, and a Hall electron concentration of 5×10¹⁷~6×10¹⁷cm⁻³.

In addition, the third repeating unit may further include a sixth u-GaN layer, and the sixth u-GaN layer, the u-In_{z}Ga_{1-z}N potential well layer, and the second n-GaN potential barrier layer are arranged in a stacked manner. In specific implementation, the sixth u-GaN layer may be deposited before the film formation of the u-In_{z}Ga_{1-z}N potential well layer and the second n-GaN potential barrier layer, and this growth mode may effectively alleviate the wavelength shift problem under a large current injection, and the performance of the display chip is further optimized. The sixth u-GaN layer may have a thickness of 2~3nm.

In some embodiments, the red quantum well light-emitting layer may include one to six (for example, three to six) fourth repeating units, and each fourth repeating unit (that is, a periodic structure of the red quantum well light-emitting layer) includes a seventh u-GaN layer, a u-In_{g}Ga_{1-g}N potential well layer (0.18≤g≤0.21, that is, an In component content is 18%~21%), a u-InₕGa₁₋ₕN potential barrier layer (0.01≤h≤0.02, that is, an In component content is 1%~2%), a u-InᵢGa₁₋ᵢN potential well layer (0.25≤i≤0.28, that is, an In component content is 25%~28%), a third n-GaN potential barrier layer, a u-InⱼGa₁₋ⱼN potential well layer (0.35≤j≤0.38, that is, an In component content is 35%~38%), a fourth n-GaN potential barrier layer, and a u-InₖGa₁₋ₖN layer (0.1≤k≤0.25, that is, an In component content is 10%~25%) that are sequentially stacked.

The seventh u-GaN layer may have a thickness of 2~3nm, the u-In_{g}Ga_{1-g}N potential well layer may have a thickness of 2.5~3nm, the u-InₕGa₁₋ₕN potential barrier layer may have a thickness of 10~15nm, the u-InᵢGa₁₋ᵢN potential well layer may have a thickness of 2.5~3nm, the third n-GaN potential barrier layer may have a thickness of 10~15nm, the u-InⱼGa₁₋ⱼN potential well layer may have a thickness of 2.5~3nm, the fourth n-GaN potential barrier layer may have a thickness of 10~15nm, and the u-InₖGa₁₋ₖN layer may have a thickness of 1~2nm.

Still referring to Fig. 1 to Fig. 13, the first semiconductor layer (that is, the n-type semiconductor layer) may include an n-AlₓGa₁₋ₓN/n-GaN superlattice layer, and an n-Al_{y}Ga_{1-y}N/n-GaN superlattice layer (lightly doped superlattice structure) located between the n-AlₓGa₁₋ₓN/n-GaN superlattice layer and the quantum well light-emitting layer, and a Hall electron concentration of the n-AlₓGa₁₋ₓN/n-GaN superlattice layer is greater than a Hall electron concentration of the n-Al_{y}Ga_{1-y}N/n-GaN superlattice layer. With the above superlattice structure, dislocation extension may be relieved, and the performance of the display chip may be further optimized.

In the embodiments of the present disclosure, unless otherwise specified, the Hall electron concentration is a measured Hall electron concentration, and the Hall hole concentration is a measured Hall hole concentration.

Specifically, the n-AlₐGa_{1-d}N/n-GaN superlattice layer includes n-AlₐGa_{1-d}N layers and fifth n-GaN layers that are arranged alternately in a first direction, that is, the n-Al_{d}Ga_{1-d}N/n-GaN superlattice layer includes at least one fifth repeating unit, each fifth repeating unit includes an n-AlₐGa_{1-d}N layer and a fifth n-GaN layer that are arranged in a stacked manner in the first direction, and a number of the fifth repeating units is a number of periods of the n-Al_{d}Ga_{1-d}N/n-GaN superlattice layer.

Wherein, 0.05≤d≤0.1, that is, an Al component content is 5%~10%, such as 5%, 6%, 7%, 8%, 9%, 10%, or in a range composed of any two of the above values.

In addition, the n-AlₐGa_{1-d}N/ layer may have a thickness of 2~2.5nm, such as 2 nm, 2.1 nm, 2.2 nm, 2.3 nm, 2.4 nm, 2.5 nm, or in a range composed of any two of the above values.

In addition, the fifth n-GaN layer may have a thickness of 7~8nm, such as 7µm, 7.1µm, 7.2µm, 7.3µm, 7.4µm, 7.5µm, 7.6µm, 7.7µm, 7.8µm, 7.9µm, 8µm, or in a range between any two of the above values.

In addition, the n-Al_{d}Ga_{1-d}N/n-GaN superlattice layer may have a thickness of 2~2.5µm, such as 2µm, 2.1µm, 2.2µm, 2.3µm, 2.4µm, 2.5µm, or in a range composed of any two of the above values.

In addition, the n-Al_{d}Ga_{1-d}N/n-GaN superlattice layer may have a Hall electron concentration of 2×10¹⁸ ~2×10¹⁹cm⁻³, such as 2×10¹⁸ cm⁻³, 3×10¹⁸ cm⁻³, 4x10¹⁸ cm⁻³, 5×10¹⁸ cm⁻³, 6×10¹⁸ cm⁻³, 7×10¹⁸ cm⁻³, 8×10¹⁸ cm⁻³, 9×10¹⁸ cm⁻³, 1×10¹⁹ cm⁻³, or in a range composed of any two of the above values.

In addition, the n-AlₑGa₁₋ₑN/n-GaN superlattice layer may have a Hall electron concentration of 1×10¹⁷~3×10¹⁷cm⁻³, such as 1×10¹⁷ cm⁻³, 1.5×10¹⁷ cm⁻³, 2×10¹⁷ cm⁻³, 2.5×10¹⁷ cm⁻³, 3×10¹⁷ cm⁻³, or in a range composed of any two of the above values.

In addition, in the n-AlₑGa₁₋ₑN/n-GaN superlattice layer, 0.01≤e≤0.03, and the n-AlₑGa₁₋ₑN/n-GaN superlattice layer may have a thickness of 0.2~0.5µm, such as 0.2µm, 0.3µm, 0.4µm, 0.5µm, or in a range composed of any two of the above values.

Still referring to Fig. 1 to Fig. 13, the epitaxial layer may further include a second u-GaN layer, a u-InₐGa₁₋ₐN/u-GaN superlattice layer (undoped superlattice structure), and a u-In_{b}Ga_{1-b}N/n-GaN superlattice layer (doped superlattice structure). The first semiconductor layer, the second u-GaN layer, the u-InₐGa₁₋ₐN/u-GaN superlattice layer, the u-In₈Ga_{1-b}N/n-GaN superlattice layer, and the quantum well light-emitting layer are sequentially stacked, and the second u-GaN layer is located between the n-Al_{y}Ga_{1-y}N/n-GaN superlattice layer and the u-InₐGa₁₋ₐN/u-GaN superlattice layer.

The second u-GaN layer is mainly used as an undoped GaN planarization layer, and may have a thickness of 15~20nm.

In addition, the u-InₐGa₁₋ₐN/u-GaN superlattice layer includes a u-InₐGa₁₋ₐN layer and a seventh u-GaN layer, the u-InₐGa₁₋ₐN layer may have a thickness of 2~2.5nm, 0.01≤a≤0.03 (that is, an In component content in the u-InₐGa₁₋ₐN layer is 1%~3%), and the seventh u-GaN layer may have a thickness of 5~15nm, such as 5nm, 8 nm, 10 nm, 13 nm, 15 nm, or in a range composed of any two of the above values.

In addition, the u-InₐGa₁₋ₐN/u-GaN superlattice layer may have a period number of 3~5. Specifically, the u-InₐGa₁₋ₐN/u-GaN superlattice layer includes at least one sixth repeating unit, each sixth repeating unit includes a u-InₐGa₁₋ₐN layer and a seventh u-GaN layer that are stacked in the first direction, and a number of the sixth repeating units is the number of periods of the u-InₐGa₁₋ₐN/u-GaN superlattice layer.

In addition, the u-In_{b}Ga_{1-b}N/n-GaN superlattice layer includes u-In_{b}Ga_{1-b}N layers and sixth n-GaN layers that are arranged alternately in the first direction, the u-In_{b}Ga_{1-b}N layer may have a thickness of 2~2.5nm, 0.03≤b≤0.08 (that is, an In component content in the u-In_{b}Ga_{1-b}N is 3%~8%), the sixth n-GaN layer may have a thickness of 5~15nm, such as 5nm, 8 nm, 10 nm, 13 nm, 15 nm, or in a range composed of any two of the above values, and the sixth n-GaN layer has a Hall electron concentration of 5×10¹⁷~6×10¹⁷cm⁻³.

In addition, the u-In_{b}Ga_{1-b}N/n-GaN superlattice layer has a period number of 3~5. Specifically, the u-In_{b}Ga_{l1b}N/n-GaN superlattice layer includes at least one seventh repeating unit, each seventh repeating unit includes a u-In_{b}Ga_{1-b}N layer and a sixth n-GaN layer that are stacked in the first direction, and a number of the seventh repeating units is the number of periods of the u-In_{b}Ga_{1-b}N/n-GaN superlattice layer.

Still referring to Fig. 1 to Fig. 13, the epitaxial layer further includes a third u-GaN layer disposed between the quantum well light-emitting layer and the second semiconductor layer (p-type semiconductor layer). In specific implementation, after the growth of the quantum well light-emitting layer is completed, the third u-GaN layer may be first deposited, and then the second semiconductor layer is grown. The third u-GaN layer is used as a protective layer, and may have a thickness of 20~30nm.

Still referring to Fig. 1 to Fig. 13, the second semiconductor layer may include an electron blocking layer, a hole providing layer, and a p-type ohmic contact layer that are sequentially stacked on a side of the quantum well light-emitting layer away from the first semiconductor layer, and the third u-GaN layer is located between the electron blocking layer and the quantum well light-emitting layer.

Specifically, the electron blocking layer may include a p-AlGaN layer and/or a p-AlGaN polarization-induced layer. The p-AlGaN layer may have an Al component content of 20~25% and a thickness of 20~60nm. The p-AlGaN polarization-induced layer has an Al component content that is graded in a thickness direction of the p-AlGaN polarization-induced layer, and specifically, the Al component content may be linearly graded from 30% to 0. The hole concentration in the film layer is about 2.5×10¹⁸cm⁻³ through theoretical calculation.

Specifically, the p-AlGaN layer is formed of a p-AlGaN material, which is generally doped with Mg. In this material system, the activation energy of the doped Mg is relatively high, and it is difficult to achieve a high hole concentration and a low resistivity. Therefore, relatively speaking, the use of the above p-AlGaN polarization-induced layer can reduce the differential resistance of the device.

In addition, the hole providing layer may include a first p-GaN layer and/or a p-Al_{f}Ga_{1-f}N/p-GaN superlattice layer.

The first p-GaN layer may have a thickness of 100~140nm, such as 100nm, 110 nm, 120 nm, 130 nm, 140 nm, or in a range composed of any two of the above values.

The p-Al_{f}Ga_{1-f}N/p-GaN superlattice layer includes p-AlₜGa_{1-f}N layer(s) and second p-GaN layer(s) that are arranged alternately in the first direction, that is, the p-Al_{f}Ga_{1-f}N/p-GaN superlattice layer includes at least one eighth repeating unit, and each eighth repeating unit includes a p-Al_{f}Ga_{1-f}N layer and a second p-GaN layer that are stacked in the first direction. The p-Al_{f}Ga_{1-f}N/p-GaN superlattice layer may have a Hall hole concentration of 1.5×10¹⁸~2.5×10¹⁸cm³, 0.15≤f≤0.25 (that is, an Al component content in the pAl_{f}Ga_{1-f}N layer is 15%~25%), the p-Al_{f}Ga_{1-f}N layer may have a thickness of 2~2.5nm, and the second p-GaN layer may have a thickness of 7~8nm.

In addition, the p-type ohmic contact layer includes 4~6 periods of p-In_{c}Ga_{1-c}N/p-GaN ohmic contact layers, and the p-In_{c}Ga_{1-c}N/p-GaN ohmic contact layer includes p-In_{c}Ga_{1-c}N layer(s) and third p-GaN layer(s) that are arranged alternately in the first direction, that is, the p-In_{c}Ga_{1-c}N/p-GaN ohmic contact layer includes at least one ninth repeating unit, each ninth repeating unit includes a p-In_{c}Ga_{1-c}N layer and a third p-GaN layer that are stacked in the first direction, and a number of the ninth repeating units is the number of periods of the p-In_{c}Ga_{1-c}N/p-GaN ohmic contact layer.

Wherein, 0.1≤c≤0.2 (that is, an In component content in the p-In_{c}Ga_{1-c}N layer is 10%~20%), the pIn_{c}Ga_{1-c}N layer has a thickness of 2~2.5nm, and the third p-GaN layer has a thickness of 7~8nm.

In addition, still referring to Fig. 1 to Fig. 13, the display chip further includes a first transparent conductive layer disposed between the second semiconductor layer and the first reflective layer, and the first transparent conductive layer is located between the p-type ohmic contact layer and the first reflective layer.

The first transparent conductive layer may have a thickness of 20~100nm, such as 20nm, 30 nm, 40 nm, 50 nm, 60 nm, 70 nm, 80 nm, 90 nm, 100 nm, or in a range composed of any two of the above values. The first transparent conductive layer may include indium tin oxide (ITO), and specifically, the first transparent conductive layer may be an ITO film layer.

Still referring to Fig. 1 to Fig. 13, the display chip further includes a base layer, the base layer includes a first substrate and a buffer layer, the first substrate and the buffer layer are located on a side of the first semiconductor layer away from the second semiconductor layer, and the first substrate, the buffer layer, and the first semiconductor layer are sequentially stacked.

Specifically, the first substrate may include a sapphire substrate, a silicon substrate, a SiC substrate, or a GaN homogeneous substrate, wherein the sapphire substrate may include a c-plane sapphire substrate, a patterned sapphire substrate, or the like.

**In** addition, the buffer layer may include one or more of an AlN buffer layer, a graded AlGaN buffer layer with a graded Al component content, and an n-AlGaN buffer layer. Wherein the n-AlGaN buffer layer is formed of an n-type doped AlGaN material.

In addition, the buffer layer may have a thickness of 15~25nm, such as 15nm, 18 nm, 20 nm, 23 nm, 25 nm, or in a range composed of any two of the above values.

**In** addition, the base layer may further include a first u-GaN layer, and the first u-GaN layer is located between the first semiconductor layer and the buffer layer, specifically, between the buffer layer and the n-AlₓGa₁₋ₓN/n-GaN superlattice layer.

**In** addition, the first u-GaN layer may have a thickness of 3~4µm, and in an X-ray diffraction test result of the first u-GaN layer, a (0002) plane ω-scan rocking curve of the first u-GaN layer has a full width at half maximum of about 70~85 arcsec, and a (10-12) plane ω-scan rocking curve of the first u-GaN layer has a full width at half maximum of 160~180 arcsec.

**In some** embodiments, as shown in Fig. 1 to Fig. 6 and Fig. 12, the first substrate is a sapphire substrate, the base layer includes the first substrate, an AlN buffer layer, and the first u-GaN layer that are stacked, and the first semiconductor layer (n-AlₓGa₁₋ₓN/n-GaN superlattice layer) is disposed on the first u-GaN layer.

**In** some embodiments, the first substrate is a silicon substrate, the base layer includes the first substrate, an AlN buffer layer, a graded AlGaN buffer layer, and the first u-GaN layer that are arranged in a stacked manner, and the first semiconductor layer (n-AlₓGa₁₋ₓN/n-GaN superlattice layer) is disposed on the first u-GaN layer.

Specifically, the Al component in the graded AlGaN buffer layer may have a decreasing trend in a direction from the buffer layer to the first u-GaN layer, and the decreasing trend may be a gradient decrease or a linear gradient decrease (that is, the graded AlGaN buffer layer may be a linear graded AlGaN layer, for example, linearly graded from AlGaN to GaN (that is, the Al component content therein is linearly graded to 0)).

**In** some embodiments, the first substrate is a SiC substrate, the base layer includes the first substrate and an n-AlGaN buffer layer that are arranged in a stacked manner, and the first semiconductor layer (n-AlₓGa₁₋ₓN/n-GaN superlattice layer) is disposed on the n-AlGaN buffer layer. In general, GaN and SiC substrate has a smaller lattice mismatch, and may be directly used for forming a vertical structure display chip.

In some embodiments, the first substrate is a GaN homogeneous substrate, and the first semiconductor layer (n-AlₓGa₁₋ₓN/n-GaN superlattice layer) is disposed on the GaN homogeneous substrate.

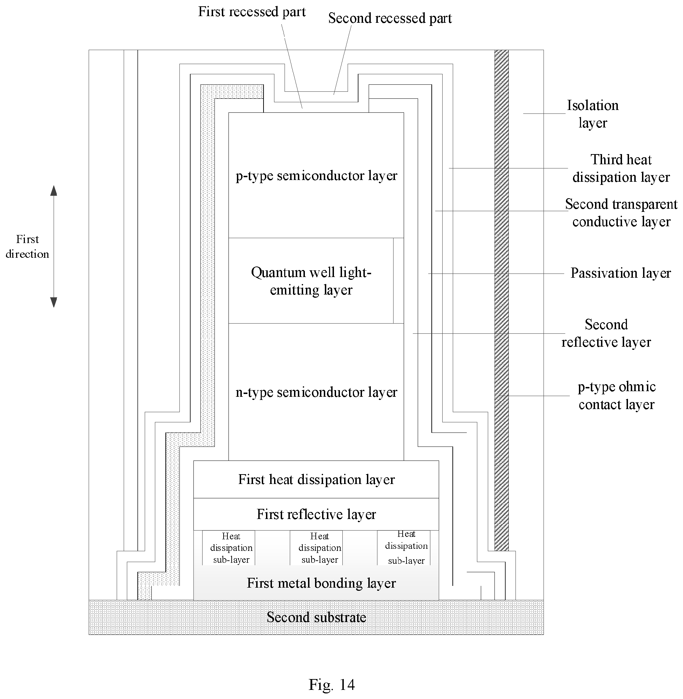

In some other embodiments, as shown in FIG. 14, the epitaxial layer may be an AlGaInP-based epitaxial structure, specifically, the epitaxial layer may be an AlGaInP red light epitaxial structure, such as an AlGaInP red light Micro-LED epitaxial structure. Wherein, the first semiconductor layer is a p-type semiconductor layer, which may specifically include a p-AlGaInP confinement layer; the second semiconductor layer is an n-type semiconductor layer, which may specifically include an n-AlGaInP confinement layer; the quantum well light-emitting layer may be an AlGaInP-based multiple quantum well light-emitting layer; the above-mentioned display chip further includes a GaAs substrate, and the GaAs substrate, the second semiconductor layer (n-type semiconductor layer), the quantum well light-emitting layer, and the first semiconductor layer (p-type semiconductor layer) are sequentially stacked.

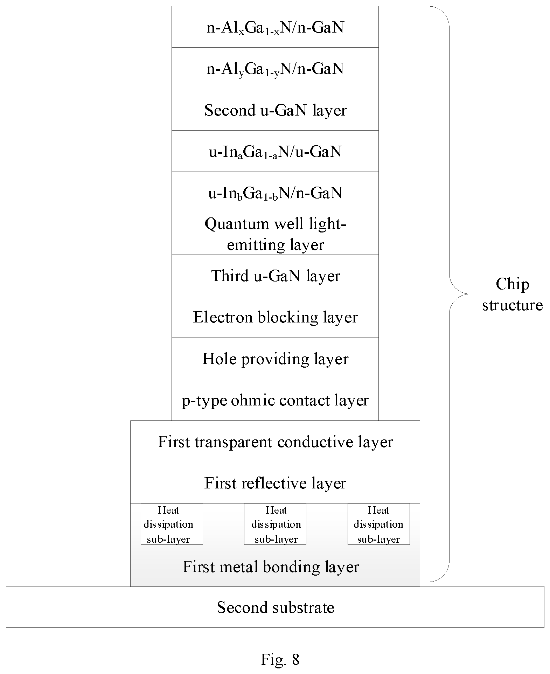

An embodiment of the present disclosure further provides a display apparatus, and as shown in Fig. 8 to Fig. 11, Fig. 13, and Fig. 14, the display apparatus includes a chip structure and a second substrate, the chip structure is formed by the display chip described above, and the chip structure is bonded to the second substrate through the first metal bonding layer.

Specifically, as shown in Fig. 8 to Fig. 11, Fig. 13, and Fig. 14, the chip structure includes the first semiconductor layer, the first metal bonding layer, and other film layers located between the first semiconductor layer and the first metal bonding layer (such as the second semiconductor layer, the quantum well light-emitting layer, etc., which may be specifically referred to the above and will not be repeated here).

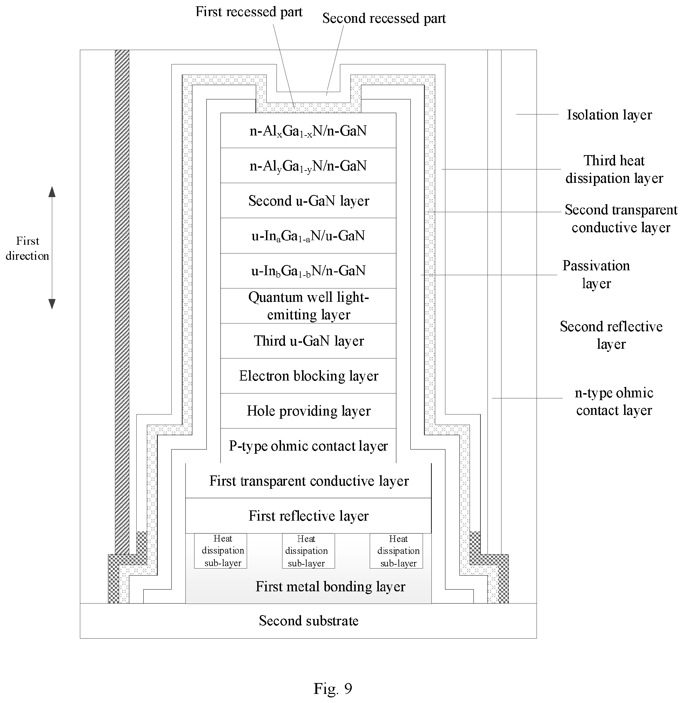

Still referring to Fig. 9, Fig. 11, Fig. 13, and Fig. 14, the display apparatus may further include a third heat dissipation layer disposed on a surface of the chip structure, the third heat dissipation layer includes a first layer portion located on a side of the first semiconductor layer away from the second semiconductor layer, and a second layer portion connected to the first layer portion, and the second layer portion extends along a sidewall of the chip structure until covering a sidewall of the first metal bonding layer. By disposing the third heat dissipation layer, the heat dissipation characteristic of the display apparatus may be further improved, and the performances such as the light-emitting brightness of the display apparatus may be enhanced.

Specifically, the third heat dissipation layer may include a material with a high thermal conductivity, and the thermal conductivity thereof may be greater than or equal to 2000 W/(m·K). In some embodiments, the third heat dissipation layer includes a diamond material and/or a graphene material.

In addition, the third heat dissipation layer may have a thickness of 50~200nm, such as 50nm, 80 nm, 100 nm, 130 nm, 150 nm, 180 nm, 200 nm, or in a range composed of any two of the above values.

Still referring to Fig. 9, Fig. 11, Fig. 13, and Fig. 14, the display apparatus may further include a second reflective layer, a passivation layer, and a second transparent conductive layer that are sequentially disposed on the surface of the chip structure, and the third heat dissipation layer is located on a surface of the second transparent conductive layer (the passivation layer and the second transparent conductive layer are located between the second reflective layer and the third heat dissipation layer).

The second transparent conductive layer penetrates through the passivation layer and the second reflective layer and then is connected to the first semiconductor layer (specifically connected to the n-AlₓGa₁₋ₓN/n-GaN superlattice layer), that is, the second reflective layer is provided with a third opening for the second transparent conductive layer to pass through, the passivation layer is provided with a fourth opening for the second transparent conductive layer to pass through, and the second transparent conductive layer passes through the fourth opening of the passivation layer and the third opening of the second reflective layer, respectively, to be connected to the first semiconductor layer. Accordingly, the second transparent conductive layer forms a first recessed part (the first recessed part passes through the fourth opening and the third opening and then is connected to the first semiconductor layer) recessed toward the first semiconductor layer at the fourth opening and the third opening, and the third heat dissipation layer also forms a second recessed part recessed toward the first semiconductor layer at the fourth opening and the third opening.

Still referring to Fig. 9, Fig. 11, Fig. 13, and Fig. 14, the display apparatus further includes a first ohmic contact layer, the first ohmic contact layer is connected to the third heat dissipation layer, and the first ohmic contact layer has a same polarity as the first semiconductor layer, that is, in a case that the first semiconductor layer is an n-type semiconductor layer (as shown in Fig. 8 to Fig. 11 and Fig. 13), the first ohmic contact layer is an n-type ohmic contact layer (n-type ohmic contact electrode), and in a case that the first semiconductor layer is a p-type semiconductor layer, the first ohmic contact layer is a p-type ohmic contact layer (as shown in FIG. 14).

Exemplarily, in the case that the first ohmic contact layer is an n-type ohmic contact layer, the first ohmic contact layer may include one or more of titanium (Ti), aluminum (Al), gold (Au), and the like, for example, the first ohmic contact layer includes a titanium layer, an aluminum layer, a titanium layer, a gold layer and the like that are sequentially stacked.

Still referring to Fig. 9, Fig. 11, Fig. 13, and Fig. 14, the display apparatus further includes an isolation layer, the isolation layer covers the third heat dissipation layer, an end of the first ohmic contact layer is connected to the third heat dissipation layer, and the other end of the first ohmic contact layer extends in a direction from the second semiconductor layer to the first semiconductor layer until penetrating through the isolation layer, that is, a surface of the first ohmic contact layer away from the second substrate is substantially level with a surface of the isolation layer away from the first substrate.

Specifically, a projection of the isolation layer on the second substrate covers projections of the chip structure, the second reflective layer, the passivation layer, the second transparent conductive layer, and the third heat dissipation layer on the second substrate.

Specifically, as shown in Fig. 9, Fig. 11, Fig. 13, and Fig. 14, the second reflective layer includes a first reflective portion located on a side of the chip structure away from the second substrate, and a second reflective portion connected to the first reflective portion and extending along the sidewall of the chip structure, that is, the second reflective portion is arranged around a periphery (sidewall) of the chip structure and covers the entire sidewall of the chip structure, that is, an end of the second extension portion in the first direction is connected to the first reflective portion, and the other end of the second extension portion is connected to the second substrate.

**In** addition, the passivation layer includes a first passivation portion located on the side of the chip structure away from the second substrate, and a second passivation portion connected to the first passivation portion and extending along a surface of the second reflective portion, that is, the second passivation portion is also arranged around the periphery of the chip structure and covers the entire sidewall of the chip structure, that is, an end of the second passivation portion in the first direction is connected to the first passivation portion, and the other end of the second passivation portion is connected to the second substrate.

In addition, the second transparent conductive layer includes a first transparent conductive portion located on the side of the chip structure away from the second substrate, and a second transparent conductive portion connected to the first transparent conductive portion and extending along a surface of the second passivation portion, that is, the second transparent conductive portion is also arranged around the periphery of the chip structure and covers the entire sidewall of the chip structure, that is, an end of the second transparent conductive portion in the first direction is connected to the first transparent conductive portion, and the other end of the second transparent conductive portion is connected to the second substrate.

In addition, the third heat dissipation layer includes a first heat dissipation portion located on the side of the chip structure away from the second substrate, and a second heat dissipation portion connected to the first heat dissipation portion and extending along a surface of the second transparent conductive portion, that is, the second heat dissipation portion is also arranged around the periphery of the chip structure and covers the entire sidewall of the chip structure, that is, an end of the second heat dissipation portion in the first direction is connected to the first heat dissipation portion, and the other end of the second heat dissipation portion is connected to the second substrate.

Specifically, the first transparent conductive portion penetrates through the first reflective portion and the first passivation portion and then is connected to the first semiconductor layer, that is, the third opening is disposed in the first reflective portion, the fourth opening is disposed in the first passivation portion, the first recessed part is disposed in the first transparent conductive portion, and the second recessed part is disposed in the first heat dissipation portion.

Exemplarily, as shown in Fig. 8, Fig. 9, Fig. 13, and Fig. 14, in the display apparatus, a projection of a composite film layer composed of the first transparent conductive layer, the first reflective layer, the heat dissipation layer (the first heat dissipation layer and/or the second heat dissipation layer), and the first metal bonding layer on the second substrate may cover a projection of the epitaxial layer (from the first semiconductor layer to the second semiconductor layer) on the second substrate, a width of the composite film layer may be greater than a width of the epitaxial layer, projections of respective film layers in the composite film layer on the second substrate may be substantially overlapped, and projections of respective film layers in the epitaxial layer on the second substrate may be substantially overlapped.

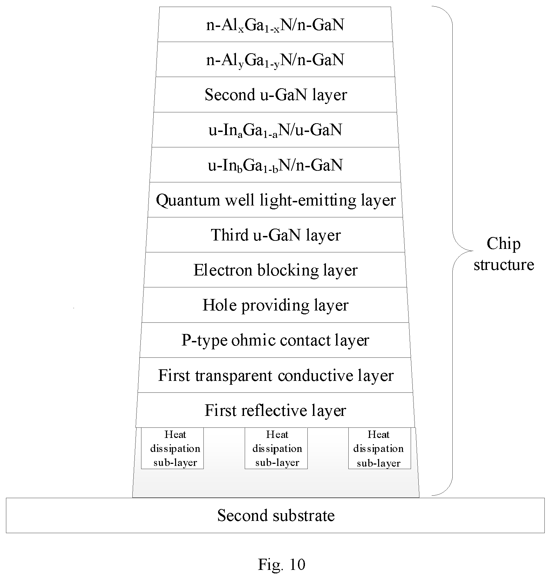

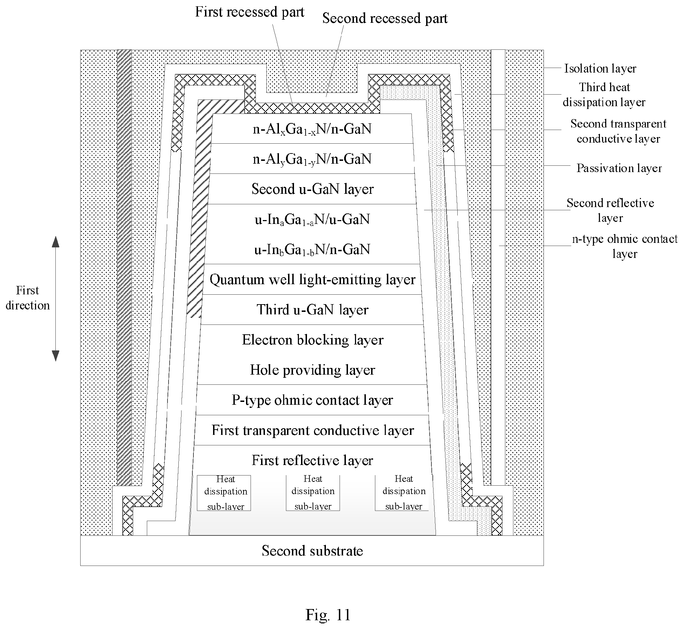

Exemplarily, as shown in Fig. 10 and Fig. 11, in the display apparatus, the chip structure may be a trapezoidal structure, that is, the first semiconductor layer, the first metal bonding layer, and respective film layers between the first semiconductor layer and the first metal bonding layer in the chip structure may be trapezoidal structures, respectively, and a width of a side of the trapezoidal structure away from the second substrate is smaller than a width of a side of the trapezoidal structure close to the second substrate.

Specifically, the second reflective layer may include Ta₂O₅ and/or SiO₂, for example, the second reflective layer may include a Ta₂O₅ /SiO₂ reflective film. Through providing the second reflective layer, the light extraction efficiency is enhanced.

Specifically, the passivation layer may include a silicon oxide compound and/or a silicon nitride compound (SiNₓ), the silicon oxide compound may specifically include silicon dioxide (SiO₂), and for example, the passivation layer may include a SiNₓ film layer and/or a SiO₂ film layer.

Specifically, the second transparent conductive layer may include ITO, and specifically, the second transparent conductive layer may be an ITO film layer.

In some embodiments, the second transparent conductive layer may have a thickness of 20~100nm, such as 20nm, 30 nm, 40 nm, 50 nm, 60 nm, 70 nm, 80 nm, 90 nm, 100 nm, or in a range composed of any two of the above values.

In a specific implementation, the display chip described above may be used, and the display chip is bonded to the second substrate, the base layer in the display chip is removed, and the sidewall thereof is etched and repaired to form a chip structure with a preset shape and size, and then the second reflective layer, the passivation layer, the second transparent conductive layer, and the third heat dissipation layer are sequentially formed on the surface of the chip structure, and then the isolation layer covering these film layers and the first ohmic contact layer connected to the third heat dissipation layer are formed to manufacture the display apparatus.

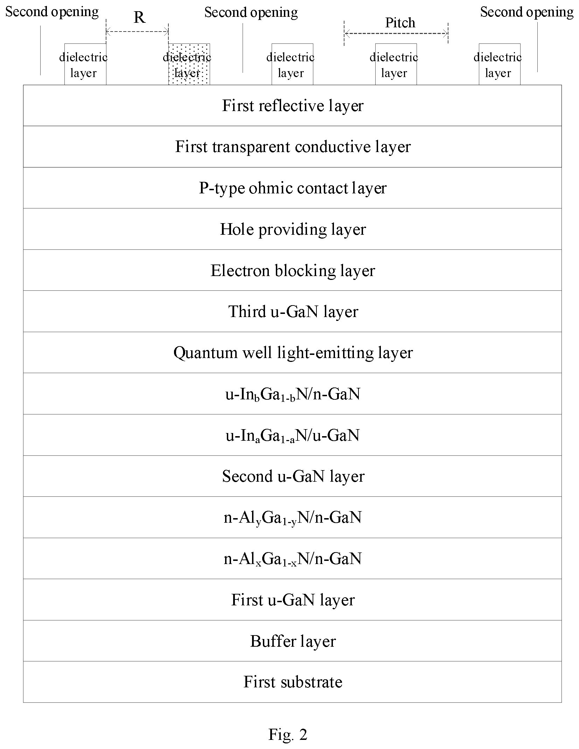

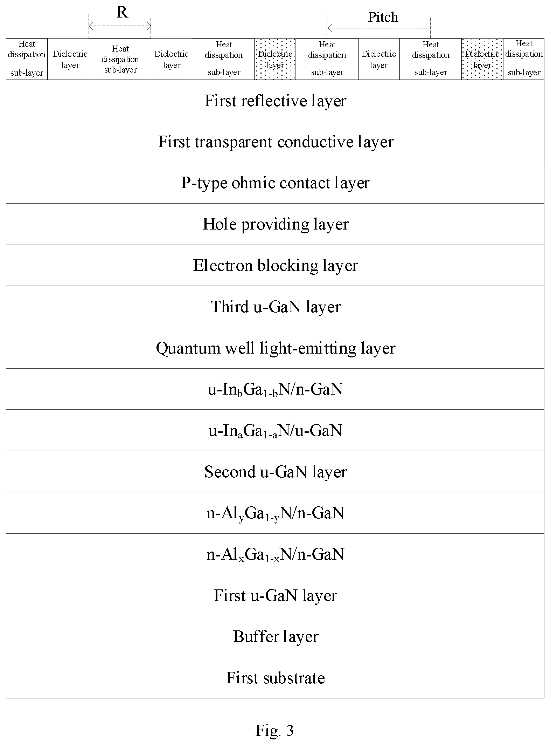

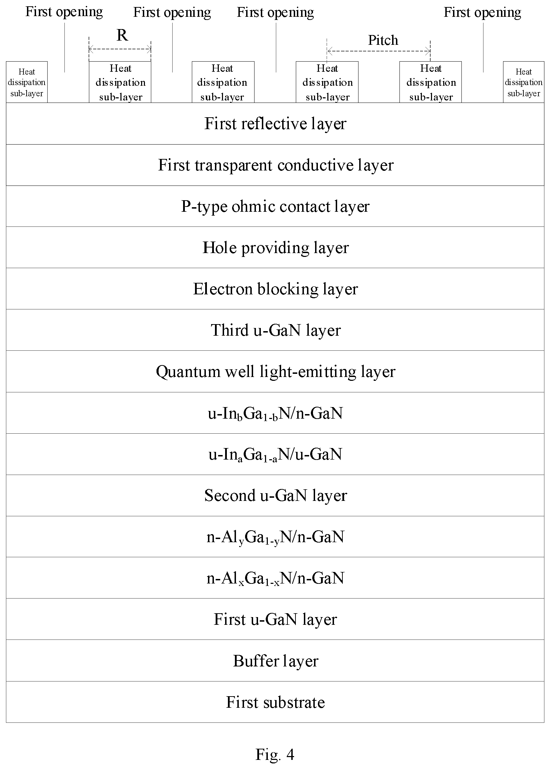

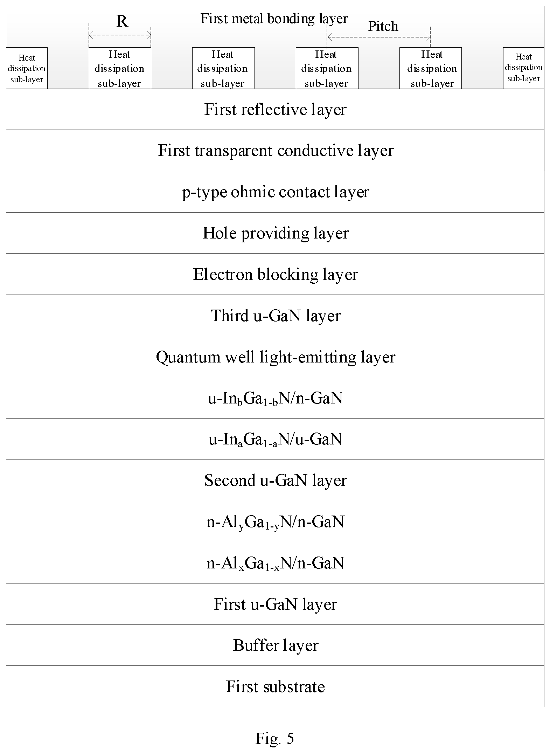

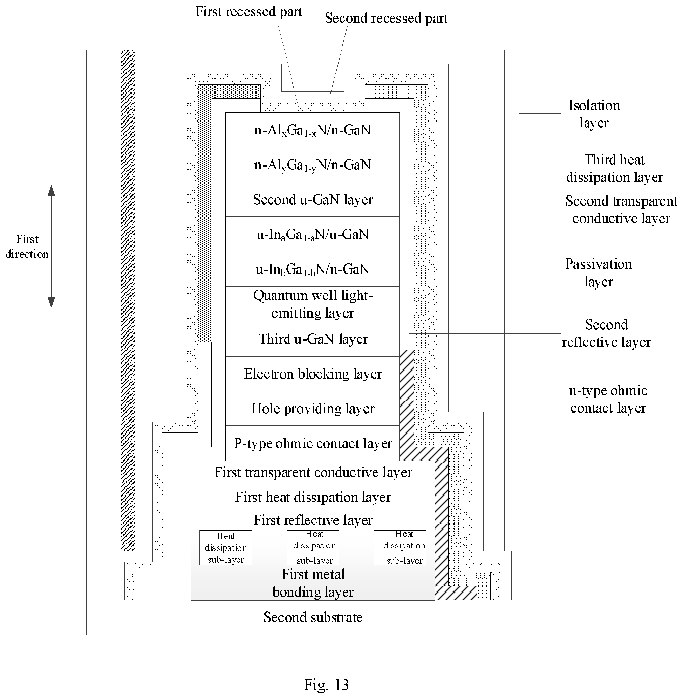

An embodiment of the present disclosure further provides a manufacturing method of the display chip described above, including the following steps: providing an epitaxial wafer for forming an epitaxial layer; forming a first reflective layer on a side of a second semiconductor layer of the epitaxial wafer away from a first semiconductor layer; and forming a first metal bonding layer on the first reflective layer, wherein, a first heat dissipation layer is formed on the side of the second semiconductor layer of the epitaxial wafer away from the first semiconductor layer first, and then the first reflective layer is formed on a side of the first heat dissipation layer away from the second semiconductor layer (as shown in Fig. 12 and Fig. 13); and/or, forming a dielectric layer on a side of the first reflective layer away from the epitaxial wafer (as shown in FIG. 1); patterning the dielectric layer to form a second opening that exposes the first reflective layer (as shown in FIG. 2); then forming a second heat dissipation layer that fills the second opening (as shown in FIG. 3); etching and removing the dielectric layer to form a first opening that exposes the first reflective layer (as shown in FIG. 4); and forming a first metal bonding layer on a side of the second heat dissipation layer away from the first reflective layer, with the first metal bonding layer being filled in the first opening (as shown in FIG. 5), and the display chip is formed.

Wherein, the dielectric layer may specifically include silicon dioxide (SiO₂) and have a thickness of 500nm~1µm.

Specifically, there may be a plurality of second openings (consistent with the number of the heat dissipation sub-layers described above), and each second opening penetrates through the dielectric layer to expose the surface of the first reflective layer.

Wherein, in a case that there are a plurality of second openings, a pitch between centers of every two adjacent second openings may be 2~20µm, such as 2µm, 5µm, 8µm, 10µm, 13µm, 15µm, 18µm, 20µm, or in a range composed of any two of the above values.

**In** addition, the second opening may have a size R of 1~10µm, such as 1µm, 1µm, 2µm, 3µm, 4µm, 5µm, 6µm, 7µm, 8µm, 9µm, 10µm, or in a range composed of any two of the above values.

Specifically, the second opening may be a hole that penetrates through the dielectric layer, such as a circular hole (that is, a projection of the second opening on the first reflective layer is substantially circular), the size of the second opening is the diameter thereof (that is, the second opening has a diameter of 1~10µm), and the center of the second opening is the circle center thereof (that is, the pitch between the centers of every two adjacent second openings as described above is a distance between circle centers of the projections of the two adjacent second openings on the first reflective layer).

In addition, the epitaxial wafer may include an InGaN-based epitaxial wafer, and the formed epitaxial layer is an InGaN-based epitaxial structure, or the epitaxial wafer may include an AlGaInP-based epitaxial wafer, and the formed epitaxial layer is an AlGaInP-based epitaxial structure.

In the embodiments of the present disclosure, unless otherwise specified, the respective film layers may be formed by conventional methods for forming these film layers in the art, for example, by depositing or growing using methods such as magnetron sputtering, chemical vapor deposition (CVD) (such as metal organic chemical vapor deposition (MOCVD), microwave plasma chemical vapor deposition (MPCVD)), 3D inkjet printing, or the like.

The following further introduces the manufacturing process of the InGaN-based epitaxial wafer as an example.

As described above, the display chip further includes the base layer, and the above manufacturing process further includes a process of sequentially forming film layers such as the buffer layer, the first u-GaN layer on the first substrate to obtain the base layer.

Specifically, in the case that the first substrate is a sapphire substrate, an AlN buffer layer is epitaxially grown on the first substrate by using a Sputter device, and then the first u-GaN layer is grown by using an MOCVD device, so as to obtain the base layer.

In the case that the first substrate is a silicon substrate, an AlN buffer layer, a graded AlN buffer layer, etc. may be epitaxially grown by using an MOCVD device, and then the first u-GaN layer is epitaxially grown, so as to obtain the base layer.

In the case that the first substrate is a SiC substrate, an n-type doped AlGaN material may be used to form an n-AlGaN buffer layer on the first substrate, so as to obtain the base layer.

In the above manufacturing process of the InGaN-based epitaxial wafer, after the base layer is obtained, an n-AlₓGa₁₋ₓN/n-GaN superlattice layer and an n-Al_{y}Ga_{1-y}N/n-GaN superlattice layer may be sequentially and epitaxially grown on a surface of the base layer (that is, a side of the first u-GaN layer (or the n-AlGaN buffer layer) away from the first substrate) by using MOCVD or the like to form the first semiconductor layer.

Wherein, in the case that the first substrate is a GaN homogeneous substrate, the n-AlₓGa₁₋ₓN/n-GaN superlattice layer and the n-Al_{y}Ga_{1-y}N/n-GaN superlattice layer may be directly epitaxially grown on the first substrate to form the first semiconductor layer.

Then, a second u-GaN layer (an undoped GaN planarization layer) is epitaxially grown on the n-Al_{y}Ga_{1-y}N/n-GaN superlattice layer; then a u-InₐGa₁₋ₐN/u-GaN superlattice layer is deposited on the second u-GaN layer, and then a u-In_{b}Ga_{1-b}N/n-GaN superlattice layer is grown on the u-InₐGa₁₋ₐN/u-GaN superlattice layer.

Then, an InGaN-based quantum well light-emitting layer is epitaxially grown on the u-In₈Ga_{1-b}N/n-GaN superlattice layer.

Then, a third u-GaN layer is deposited on the quantum well light-emitting layer.

Then, an electron blocking layer, a hole providing layer (for example, depositing the first p-GaN layer, etc.), and a p-type ohmic contact layer (such as depositing a p-In_{c}Ga_{1-c}N/p-GaN ohmic contact layer, etc.) are sequentially grown on the third u-GaN layer.

Then, the first transparent conductive layer is formed on the p-type ohmic contact layer to obtain the InGaN-based epitaxial wafer. Specifically, an ITO film layer may be deposited on the p-type ohmic contact layer and annealed to form the first transparent conductive layer. By combining the annealing process, the transmittance of the ITO film layer (the first transparent conductive layer) may be improved, and the material resistance may be reduced.

Then, the first reflective layer is formed (e.g., an Ag mirror is deposited) on the first transparent conductive layer.

Then, as shown in Fig. 1 and Fig. 2, the dielectric layer is formed (e.g., a SiO₂ material is deposited) on the first reflective layer and patterned to form the second opening that exposes the first reflective layer (that is, the second opening penetrates through the dielectric layer).

Then, as shown in FIG. 3, the second heat dissipation layer is formed on the patterned dielectric layer, for example, a diamond material may be deposited by using MPCVD, 3D inkjet printing, or the like to form the second heat dissipation layer.

Then, as shown in FIG. 4, the dielectric layer is etched and removed to expose the first reflective layer covered by the patterned dielectric layer. Wherein in the case that the dielectric layer is made of the SiO₂ material, a BOE solution may be used to etch the dielectric layer until the first reflective layer is exposed.

Then, as shown in FIG. 5, a metal material for forming the first metal bonding layer is deposited on the second heat dissipation layer and the first reflective layer not covered by the second heat dissipation layer (that is, the first reflective layer exposed after the dielectric layer is removed), so as to form the first metal bonding layer, thereby obtaining the display chip.

In some other embodiments, as shown in FIG. 12, after the first transparent conductive layer is formed, the first heat dissipation layer may be first formed on the first transparent conductive layer, for example, a graphene material is deposited by using CVD, 3D inkjet printing, or the like, and is annealed through vacuum annealing and/or laser annealing to form the first heat dissipation layer. Wherein, the vacuum annealing or laser annealing process is combined to improve the material compactness and the electrical conductivity of the first heat dissipation layer. Then, films layers such as the first reflective layer, the second heat dissipation layer, and the first metal bonding layer may be sequentially formed (by forming methods which can be referred to the above description and will not be repeated here) on the first heat dissipation layer, thereby obtaining the display chip with the first heat dissipation layer and the second heat dissipation layer.

An embodiment of the present disclosure further provides a manufacturing method of the display apparatus described above, including the following steps: manufacturing the display chip according to the manufacturing method of the display chip described above; and bonding the display chip to the second substrate through the first metal bonding layer, thereby manufacturing the display apparatus.

Specifically, the process of bonding the display chip to the second substrate through the first metal bonding layer may include: depositing a second metal bonding layer on the second substrate, and then bonding (connecting) the first metal bonding layer of the display chip to the second metal bonding layer of the second substrate.

Specifically, the second metal bonding layer includes a metal, such as one or more of chromium (Cr), platinum (Pt), silver (Ag), indium (In), and the like. Exemplarily, the second metal bonding layer is a multi-layer structure, that is, the second metal bonding layer includes a plurality of metal layers, for example, include a chromium layer, a platinum layer, a silver layer, an indium layer, and the like that are sequentially stacked on the second substrate.

Specifically, as described above, the second substrate may include a silicon substrate or a silicon-based complementary metal oxide semiconductor (CMOS) pixel driving circuit.

In some embodiments, the epitaxial wafer is an InGaN-based epitaxial wafer, and as described above, the InGaN-based epitaxial wafer further includes the base layer located on the side of the first semiconductor layer away from the second semiconductor layer, and the manufacturing method of the display apparatus further includes the following steps S101~S105.

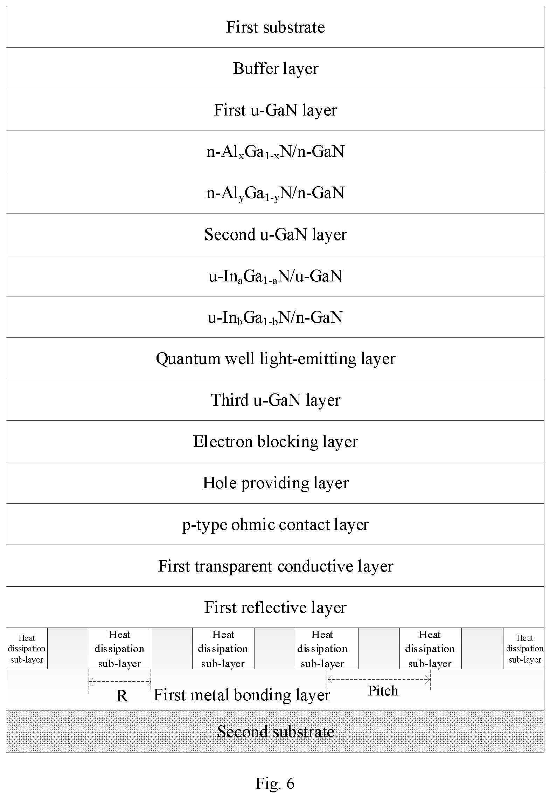

S101, bonding the display chip to the second substrate through the first metal bonding layer (as shown in FIG. 6).

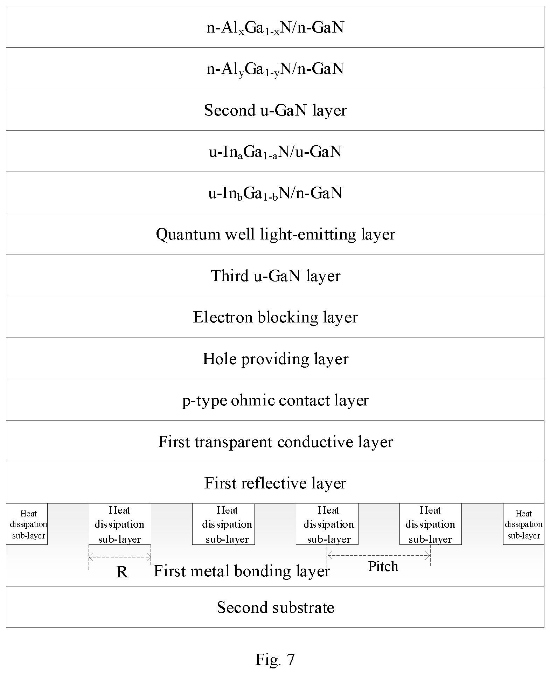

S102, removing the base layer to expose the first semiconductor layer (as shown in FIG. 7).

In a specific implementation, film layers such as the substrate and the first u-GaN layer in the base layer may be removed by a conventional method in the art, for example, in the case that the first substrate in the base layer is a sapphire substrate, the sapphire substrate may be removed by a laser lift-off (LLO) process; in the case that the first substrate in the base layer is a silicon substrate, the silicon substrate may be removed by wet etching; in the case that the first substrate in the base layer is a SiC substrate, it may be removed by laser lift-off or grinding.

Exemplarily, in the case that the first substrate in the base layer is a sapphire substrate, after the display chip is bonded to the second substrate, the sapphire substrate may be removed by the laser lift-off (LLO) process, and the first u-GaN layer is etched by an inductively coupled plasma etching (ICP-RIE) process until etching to the first semiconductor layer (that is, the first semiconductor layer is exposed), and the first semiconductor layer is planarized and polished, and then the subsequent steps are performed.

S103, then, etching the display chip according to a preset parameter of the chip structure to form the chip structure (as shown in Fig. 8 and Fig. 10).

In a specific implementation, the display chip may be etched (by mainly etching the sidewall thereof) according to parameters such as a preset pixel size and a pixel pitch of the display apparatus, and specifically, the etching may be performed by the ICP-RIE process, so as to form the chip structure that meets the parameters such as the preset size. For example, a blue light chip (the quantum well light-emitting layer of the display chip is a blue quantum well light-emitting layer), a green light chip (the quantum well light-emitting layer of the display chip is a green quantum well light-emitting layer), and a red light chip (the quantum well light-emitting layer of the display chip is a red quantum well light-emitting layer) may be manufactured respectively according to the manufacturing method of the display chip described above, and then the blue light chip, the green light chip, and the red light chip are etched respectively according to parameters such as different pixel sizes and pixel pitches to form a blue light chip structure (B), a green light chip structure (G), and a red light chip structure (R) respectively, and then the blue light chip structure (B), the green light chip structure (G), and the red light chip structure (R) are bonded to the second substrate respectively according to the manufacturing method of the display apparatus of the embodiment of the present disclosure to manufacture an RGB Micro-LED chip.

After the display chip is etched, a sidewall repair process (such as wet etching) may be used to repair the etched interface (such as a sidewall surface) of the formed chip structure to reduce defect density, and then a subsequent step (forming the second reflective layer on the surface of the chip structure) is performed.

S104, then, sequentially forming the second reflective layer, the passivation layer, the second transparent conductive layer, and the third heat dissipation layer on the surface of the chip structure, wherein the second transparent conductive layer penetrates through the passivation layer and the second reflective layer to be connected to the first semiconductor layer(as shown in Figs. 9, 11, and 13).

Exemplarily, a Ta₂O₅ /SiO₂ reflective film may be deposited on the surface of the chip structure to form the second reflective layer, and SiO₂ /SiNₓ may be deposited by a plasma enhanced chemical vapor deposition (PECVD) method, an atomic layer deposition (ALD) method, or the like to form the passivation layer.

Exemplarily, an ITO film layer may be deposited on the surface of the passivation layer and annealed to form the second transparent conductive layer. By combining the annealing process, the transmittance of the ITO film layer (the second transparent conductive layer) may be improved, and the material resistance may be reduced.

Exemplarily, a graphene material may be deposited on the surface of the second transparent conductive layer by using CVD, inkjet printing, or the like, and the graphene material is annealed through a process such as vacuum annealing and/or laser annealing to form the third heat dissipation layer. The vacuum annealing or laser annealing process is combined to improve the material compactness and the electrical conductivity of the third heat dissipation layer.

S105, then, forming the first ohmic contact layer connected to the third heat dissipation layer, thereby obtaining the display apparatus ((as shown in Figs. 9, 11, and 13)).

In some other embodiments, the epitaxial wafer is an AlGaInP-based epitaxial wafer, the AlGaInP-based epitaxial wafer includes a GaAs substrate, and the manufacturing method of the display apparatus further includes the following steps S201~S208.

S201, etching the AlGaInP-based epitaxial wafer according to a preset parameter of the chip structure.

As described above, the display chip may be etched (by mainly etching the sidewall thereof, specifically, the etching may be performed by the ICP-RIE process) according to parameters such as a preset pixel size and a pixel pitch of the display apparatus, so as to form the chip structure that meets the parameters such as the preset size after the subsequent steps S202~S206.

S202, then, bonding the first semiconductor layer (p-type semiconductor layer) of the etched AlGaInP-based epitaxial wafer to a transfer substrate.

The transfer substrate may include a sapphire substrate, a silicon substrate, or the like.

A protective film layer may be further disposed between the transfer substrate and the first semiconductor layer, and an adhesive is disposed between the protective film layer and the transfer substrate.

S203, then, removing the GaAs substrate (that is, lifting-off the GaAs substrate) to expose the second semiconductor layer (n-type semiconductor layer).

S204, then, forming the first reflective layer, the first metal bonding layer, and the heat dissipation layer on a side of the second semiconductor layer of the epitaxial wafer away from the first semiconductor layer, the heat dissipation layer including the first heat dissipation layer and/or the second heat dissipation layer, thereby obtaining the display chip. For the formation process of these film layers, specifically, reference may be made to the above, and details are not repeated here.

S205, bonding the display chip to the second substrate through the first metal bonding layer.

S206, then, removing the transfer substrate and exposing the first semiconductor layer to form the chip structure.

In a specific implementation, the transfer substrate is lifted-off, and the adhesive and the protective film layer are removed to expose the first semiconductor layer. Then, a sidewall repair process (such as wet etching) may be used to repair the etched interface (such as a sidewall surface) of the formed chip structure to reduce the defect density, and then a subsequent step (forming the second reflective layer on the surface of the chip structure) is performed.

S207, then, sequentially forming the second reflective layer, the passivation layer, the second transparent conductive layer, and the third heat dissipation layer on the surface of the chip structure, wherein the second transparent conductive layer penetrates through the passivation layer and the second reflective layer to be connected to the first semiconductor layer. For the formation process of these film layers, reference may be made to the above, and details are not repeated here.

S208, then, forming the first ohmic contact layer connected to the third heat dissipation layer, thereby obtaining the display apparatus (as shown in FIG. 14).

In addition, as described above, the display apparatus may further include the isolation layer, and the manufacturing process of the display apparatus may further include a process of forming the isolation layer. The isolation layer may include SiO₂, which may specifically be a SiO₂ film layer formed of SiO₂.

In the description of the present disclosure, "n-" represents n-type doped, for example, each of the n-GaN layer, the n-AlₓGa₁₋ₓN/n-GaN superlattice layers, etc. described above all represent n-type doped layers, and a conventional dopant in the art may be used, for example, the dopant includes SiH₄; "p-" represents p-type doped, for example, the p-GaN layer, the p-AlGaN layer, the p-Al_{f}Ga_{1-f}N/p-GaN superlattice layer, etc. described above all represent p-type doped layers, and a conventional dopant in the art may also be used; "u-" represents undoped, for example, the u-GaN layer represents an undoped gallium nitride film layer, etc. In addition, unless otherwise specified, the "content" refers to the molar content, the thickness direction of the "thickness" as described above is parallel to the first direction, and the first direction is parallel to the direction from the first semiconductor layer to the second semiconductor layer.

In addition, terms such as "first" and "second" are only used for descriptive purposes, for example, to distinguish between various components, so as to illustrate/explain the technical solution more clearly, and cannot be understood as indicating or implying the number of technical features indicated or an order of substantial significance.

In addition, unless otherwise specified and limited, terms such as "disposed", "arranged", "connected", and "coupled" should be understood broadly, for example, it may be a fixed connection, a detachable connection, or an integrated connection; may be a mechanical connection, an electrical connection, or a communication connection (network connection); or may be a direct connection, an indirect connection through an intermediate medium, or internal communication of two elements. For those of ordinary skill in the art, the specific meaning of the above in the present invention may be understood on a case-by-case basis.

Finally, it should be noted that the above embodiments are only used to illustrate the technical solutions of the present invention, rather than limiting the present invention; although the present invention has been described in detail with reference to the foregoing embodiments, those of ordinary skill in the art should understand that they may still modify the technical solutions recorded in the foregoing embodiments, or equivalently replace some or all of the technical features; and these modifications or replacements do not make the essence of the corresponding technical solutions depart from the scope of the technical solutions of the embodiments of the present invention.

## Claims

1. A display chip, comprising:
an epitaxial layer, wherein the epitaxial layer comprises a first semiconductor layer, a quantum well light-emitting layer, and a second semiconductor layer that are sequentially stacked, and one of the first semiconductor layer and the second semiconductor layer is an n-type semiconductor layer, and the other one of the first semiconductor layer and the second semiconductor layer is a p-type semiconductor layer;
a first reflective layer, located on a side of the second semiconductor layer away from the first semiconductor layer;
a first metal bonding layer, located on a side of the first reflective layer away from an epitaxial structure; and
a heat dissipation layer, wherein the heat dissipation layer comprises a first heat dissipation layer and/or a second heat dissipation layer, the first heat dissipation layer is located between the epitaxial structure and the first reflective layer, the second heat dissipation layer is located on a side of the first reflective layer away from the epitaxial structure, the second heat dissipation layer is provided with a first opening that exposes the first reflective layer, and the first metal bonding layer is disposed on a side of the second heat dissipation layer away from the first reflective layer and fills the first opening.

2. The display chip of claim 1, wherein
the first heat dissipation layer comprises a diamond material and/or a graphene material;
and/or, a thickness of the first heat dissipation layer is 100~300nm;
and/or, the second heat dissipation layer comprises a diamond material and/or a graphene material;
and/or, a thickness of the second heat dissipation layer is 10~20µm;
and/or, the second heat dissipation layer comprises a plurality of heat dissipation sub-layers, and every two adjacent heat dissipation sub-layers are spaced apart by the first opening, a size of each of the plurality of heat dissipation sub-layers is 1~10µm, and/or a distance between centers of every two adjacent heat dissipation sub-layers is 2~20µm.

3. The display chip of claim 1, wherein the epitaxial layer is an InGaN-based epitaxial structure, the first semiconductor layer is an n-type semiconductor layer, and the second semiconductor layer is a p-type semiconductor layer.

4. The display chip of claim 3, wherein the first semiconductor layer comprises an n-AlₓGa₁₋ₓN/n-GaN superlattice layer and an n-Al_{y}Ga_{1-y}N/n-GaN superlattice layer located between the n-AlₓGa₁₋ₓN/n-GaN superlattice layer and the quantum well light-emitting layer, and a Hall electron concentration of the n-AlₓGa₁₋ₓN/n-GaN superlattice layer is greater than a Hall electron concentration of the n-Al_{y}Ga_{1-y}N/n-GaN superlattice layer.

5. The display chip of claim 4, wherein
the n-AlₐGa_{1-d}N/n-GaN superlattice layer has a Hall electron concentration of 2×10¹⁸ ~2×10¹⁹cm⁻³;
and/or, the n-AlₐGa_{1-d}N/n-GaN superlattice layer comprises an n-AlₐGa_{1-d}N layer and a fifth n-GaN layer, 0.05≤d≤0.1, the n-AlₐGa_{1-d}N layer has a thickness of 2~2.5 nm, and the fifth n-GaN layer has a thickness of 7~8nm;
and/or, the n-AlₐGa_{1-d}N/n-GaN superlattice layer has a thickness of 2~2.5µm;
and/or, the n-AlₑGa₁₋ₑN/n-GaN superlattice layer has a Hall electron concentration of 1×10¹⁷~3×10¹⁷cm⁻³;
and/or, in the n-AlₑGa₁₋ₑN/n-GaN superlattice layer, 0.01≤e≤0.03;
and/or, the n-AlₑGa₁₋ₑN/n-GaN superlattice layer has a thickness of 0.2~0.5µm.

6. The display chip of claim 3, wherein the epitaxial layer further comprises a second u-GaN layer, a u-InₐGa₁₋ₐN/u-GaN superlattice layer, and a u-In_{b}Ga_{1-b}N/n-GaN superlattice layer, and the n-type semiconductor layer, the second u-GaN layer, the u-InₐGa₁₋ₐN/u-GaN superlattice layer, the u-In_{b}Ga_{1-b}N/n-GaN superlattice layer, and the quantum well light-emitting layer are sequentially stacked;
and/or, the u-InₐGa₁₋ₐN/u-GaN superlattice layer comprises a u-InₐGa₁₋ₐN layer and a seventh u-GaN layer, the u-InₐGa₁₋ₐN layer has a thickness of 2~2.5nm, 0.01≤a≤0.03, and the seventh u-GaN layer has a thickness of 5~15nm;
and/or, the u-InₐGa₁₋ₐN/u-GaN superlattice layer has a period number of 3~5;
and/or, the u-In_{b}Ga_{1-b}N/n-GaN superlattice layer comprises a u-In_{b}Ga_{1-b}N layer and a sixth n-GaN layer, the u-In_{b}Ga_{1-b}N layer has a thickness of 2~2.5nm, 0.03≤b≤0.08, the sixth n-GaN layer has a thickness of 5~15nm, and the sixth n-GaN layer has a Hall electron concentration of 5×10¹⁷~6×10¹⁷cm⁻³;
and/or, the u-In_{b}Ga_{1-b}N/n-GaN superlattice layer has a period number of 3~5.

7. The display chip of claim 3, wherein the epitaxial layer further comprises a third u-GaN layer disposed between the quantum well light-emitting layer and the second semiconductor layer and/or a first transparent conductive layer disposed between the second semiconductor layer and the first reflective layer.

8. The display chip of claim 3, wherein the second semiconductor layer comprises an electron blocking layer, a hole providing layer, and a p-type ohmic contact layer that are sequentially stacked on a side of the quantum well light-emitting layer away from the first semiconductor layer, wherein,
the electron blocking layer comprises a p-AlGaN polarization-induced layer, and an Al component content in the p-AlGaN polarization-induced layer is linearly graded from 30% to 0 in a thickness direction of the p-AlGaN polarization-induced layer;
and/or, the hole providing layer comprises a first p-GaN layer and/or a p-Al_{f}Ga_{1-f}N/p-GaN superlattice layer, the first p-GaN layer has a thickness of 100~140nm; the p-Al_{f}Ga_{1-f}N/p-GaN superlattice layer comprises a p-Al_{f}Ga_{1-f}N layer and a second p-GaN layer, the p-Al_{f}Ga_{1-f}N layer has a thickness of 2~2.5nm, 0.15≤f≤0.25, a Hall hole concentration of 1.5×10¹⁸~2.5×10¹⁸cm⁻³, and the second p-GaN layer has a thickness of 7~8nm;
and/or, the p-type ohmic contact layer comprises a p-In_{c}Ga_{1-c}N/p-GaN ohmic contact layer with 4~6 periods, the p-In_{c}Ga_{1-c}N/p-GaN superlattice layer comprises a p-In_{c}Ga_{1-c}N layer and a third p-GaN layer, the pIn_{c}Ga_{1-c}N layer has a thickness of 2~2.5nm, 0.1≤c≤0.2, and the third p-GaN layer has a thickness of 7~8nm.

9. The display chip of claim 3, further comprising a base layer, wherein the base layer comprises a first substrate located on a side of the first semiconductor layer away from the second semiconductor layer, wherein,
the first substrate is a sapphire substrate, the base layer further comprises an AlN buffer layer and a first u-GaN layer that are located between the first substrate and the first semiconductor layer, and the first semiconductor layer is disposed on the first u-GaN layer;
or, the first substrate is a silicon substrate, the base layer further comprises an AlN buffer layer, a graded AlGaN buffer layer with a graded Al component content, and a first u-GaN layer, the first substrate, the AlN buffer layer, the graded AlGaN buffer layer, and the first u-GaN layer are sequentially stacked, and the first semiconductor layer is disposed on the first u-GaN layer;
or, the first substrate is a SiC substrate, the base layer further comprises an n-AlGaN buffer layer, and the first semiconductor layer is disposed on the n-AlGaN buffer layer;
or, the first substrate is a GaN homogeneous substrate, and the first semiconductor layer is disposed on the GaN homogeneous substrate.

10. The display chip of claim 1 or 3, wherein the quantum well light-emitting layer comprises one or more of a blue quantum well light-emitting layer, a green quantum well light-emitting layer, or a red quantum well light-emitting layer.

11. The display chip of claim 10, wherein,
the blue quantum well layer comprises three to six first repeating units, each of the first repeating units comprises a u-InₘGa₁₋ₘN potential well layer and a u-In_{q}Ga_{1-q}N potential barrier layer that are arranged in a stacked manner, 0.18≤m≤0.21, 0.01≤q≤0.02, the u-InₘGa₁₋ₘN potential well layer has a thickness of 2.5~3nm, and the u-In_{q}Ga_{1-q}N potential barrier layer has a thickness of 10~15nm;
and/or, the green quantum well light-emitting layer comprises one to two second repeating units and two to three third repeating units, the second repeating unit comprises a u-In_{w}Ga_{1-w}N potential well layer and a first n-GaN potential barrier layer that are arranged in a stacked manner, 0.24≤w≤0.25, the u-In_{w}Ga_{1-w}N potential well layer has a thickness of 2.5~3nm, and the first n-GaN potential barrier layer has a thickness of 10~15nm; the third repeating unit comprises a u-In_{z}Ga_{1-z}N potential well layer and a second n-GaN potential barrier layer that are arranged in a stacked manner, 0.25≤z≤0.28, the u-In_{z}Ga_{1-z}N potential well layer has a thickness of 2.5~3nm, and the second n-GaN potential barrier layer has a thickness of 10~15nm;
and/or, the red quantum well light-emitting layer comprises one to six fourth repeating units, each of the fourth repeating units comprises a seventh u-GaN layer, a u-In_{g}Ga_{1-g}N potential well layer with a thickness of 2.5~3nm, a u-InₕGa₁₋ₕN potential barrier layer with a thickness of 10~15nm, a u-InᵢGa₁₋ᵢN potential well layer with a thickness of 2.5~3nm, a third n-GaN potential barrier layer with a thickness of 10~15nm, a u-InⱼGa₁₋ⱼN potential well layer with a thickness of 2.5~3nm, a fourth n-GaN potential barrier layer with a thickness of 10~15nm, and a u-InₖGa₁₋ₖN layer with a thickness of 1~2nm that are sequentially stacked, 0.18≤g≤0.21, 0.01≤h≤0.02, 0.25≤i≤0.28, 0.35≤j≤0.38, 0.1≤k≤0.25.

12. The display chip of claim 1 or 2, wherein the epitaxial layer is an AlGaInP-based epitaxial structure, the first semiconductor layer is a p-type semiconductor layer, and the second semiconductor layer is an n-type semiconductor layer.

13. A display apparatus, comprising a chip structure and a second substrate, wherein the chip structure is formed by the display chip of any of claims 1 to 12, and the chip structure is bonded to the second substrate through the first metal bonding layer.

14. The display apparatus of claim 13, further comprising a third heat dissipation layer disposed on a surface of the chip structure, wherein the third heat dissipation layer comprises a first layer portion located on a side of the first semiconductor layer away from the second semiconductor layer, and a second layer portion connected to the first layer portion, and the second layer portion extends along a sidewall of the chip structure until covering a sidewall of the first metal bonding layer.

15. The display apparatus of claim 14, wherein,
the third heat dissipation layer comprises a diamond material and/or a graphene material;
and/or, the third heat dissipation layer has a thickness of 50~200nm.

16. The display apparatus of claim 14, further comprising a second reflective layer, a passivation layer, and a second transparent conductive layer that are sequentially disposed on the surface of the chip structure, wherein the third heat dissipation layer is located on a surface of the second transparent conductive layer;
the second transparent conductive layer penetrates through the passivation layer and the second reflective layer to be connected to the first semiconductor layer;
the display apparatus further comprises a first ohmic contact layer, and the first ohmic contact layer is connected to the third heat dissipation layer; and
the display apparatus further comprises an isolation layer, the isolation layer covers the third heat dissipation layer, and the first ohmic contact layer has an end connected to the third heat dissipation layer and another end extending in a direction from the second semiconductor layer to the first semiconductor layer until penetrating through the isolation layer.

17. A manufacturing method of the display chip of any of claims 1 to 12, comprising:
providing an epitaxial wafer for forming the epitaxial layer;
forming the first reflective layer on a side of the second semiconductor layer of the epitaxial wafer away from the first semiconductor layer; and
forming the first metal bonding layer on the first reflective layer,
wherein
the first heat dissipation layer is formed on the side of the second semiconductor layer of the epitaxial wafer away from the first semiconductor layer first, and then the first reflective layer is formed on a side of the first heat dissipation layer away from the second semiconductor layer;
and/or
a dielectric layer is formed on a side of the first reflective layer away from the epitaxial wafer;
the dielectric layer is patterned to form a second opening that exposes the first reflective layer;
then the second heat dissipation layer that fills the second opening is formed;
the dielectric layer is etched and removed to form a first opening that exposes the first reflective layer; and
the first metal bonding layer is formed on a side of the second heat dissipation layer away from the first reflective layer, and the first metal bonding layer fills the first opening.

18. The manufacturing method of the display chip of claim 17, wherein the dielectric layer comprises silicon dioxide.

19. A manufacturing method of a display apparatus of any of claims 13 to 16, comprising:
manufacturing the display chip according to the manufacturing method of the display chip of claim 17 or 18; and
bonding the display chip to the second substrate through the first metal bonding layer, and the display apparatus is obtained.

20. The manufacturing method of a display apparatus of claim 19, wherein,
the epitaxial wafer is an InGaN-based epitaxial wafer, the InGaN-based epitaxial wafer further comprises a base layer located on a side of the first semiconductor layer away from the second semiconductor layer, and the manufacturing method of the display apparatus further comprises:
bonding the display chip to the second substrate through the first metal bonding layer;
removing the base layer to expose the first semiconductor layer;
then, etching the display chip according to a preset parameter of the chip structure to form the chip structure;
then, sequentially forming a second reflective layer, a passivation layer, a second transparent conductive layer, and a third heat dissipation layer on a surface of the chip structure, wherein the second transparent conductive layer penetrates through the passivation layer and the second reflective layer to be connected to the first semiconductor layer; and
then, forming a first ohmic contact layer connected to the third heat dissipation layer;
or
the epitaxial wafer is an AlGaInP-based epitaxial wafer, the AlGaInP-based epitaxial wafer comprises a GaAs substrate, and the manufacturing method of the display apparatus further comprises:
etching the AlGaInP-based epitaxial wafer according to a preset parameter of the chip structure;
then, bonding the first semiconductor layer of the AlGaInP-based epitaxial wafer that has been etched to a transfer substrate;
then, removing the GaAs substrate and exposing the second semiconductor layer;
then, forming the first reflective layer, the first metal bonding layer, and the heat dissipation layer on a side of the second semiconductor layer of the epitaxial wafer away from the first semiconductor layer, the heat dissipation layer comprising the first heat dissipation layer and/or the second heat dissipation layer, thereby obtaining the display chip;
bonding the display chip to the second substrate through the first metal bonding layer;
then, removing the transfer substrate and exposing the first semiconductor layer to form the chip structure;
then, sequentially forming a second reflective layer, a passivation layer, a second transparent conductive layer, and a third heat dissipation layer on a surface of the chip structure, wherein the second transparent conductive layer penetrates through the passivation layer and the second reflective layer to be connected to the first semiconductor layer; and
then, forming a first ohmic contact layer connected to the third heat dissipation layer.
